(19) **Europäisches Patentamt**
**European Patent Office**
**Office européen des brevets**

(11) **EP 3 481 146 A1**

(12) **EUROPEAN PATENT APPLICATION**

(43) Date of publication:
**08.05.2019 Bulletin 2019/19**

(51) Int Cl.:
**H05B 3/56** $^{(2006.01)}$ **H05B 3/00** $^{(2006.01)}$

(21) Application number: **18204472.7**

(22) Date of filing: **05.11.2018**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **03.11.2017 US 201762581231 P**

(71) Applicant: **Pentair Thermal Management LLC
Redwood City, CA 94063 (US)**

(72) Inventors:
• **SHIRKHANI, Arsham
Redwood City, CA 94063 (US)**
• **KAZEMI, Mohammad
San Jose, CA 95138 (US)**

(74) Representative: **Barker Brettell LLP
100 Hagley Road
Edgbaston
Birmingham B16 8QQ (GB)**

(54) **INRUSH LIMIT OF SELF-REGULATING HEATING CABLES**

(57)    The invention includes a system for reducing inrush current of a self-regulating heating cable 110. The system includes a power supply 105 configured to provide an input voltage to the self-regulating heating cable. The system further includes a passive element 115 configured to reduce the inrush current. The power supply, the passive element, and the self-regulating heating cable are connected in series.

FIG. 1A

**Description**

CROSS-REFERENCE TO RELATED APPLICATIONS

This application is a non-provisional claiming the benefit of U.S. Prov. Pat. App. Ser. No. 62/581,231, filed under the same title on November 3, 2017, and incorporated fully herein by reference.

BACKGROUND OF THE INVENTION

The present invention relates to limiting inrush current, and particularly to systems and methods for limiting a high inrush current associated with self-regulating heating cables.

When a Self-Regulating (SR) cable is energized, an initial inrush current can be extremely high. Conventional solutions often require large circuit breakers to manage this high inrush current, or alternatively, the maximum allowed circuit length may be shortened. Certain applications that are affected by high initial inrush currents can utilize duty cycling or negative temperature coefficient (NTC) components to soften the inrush current, however this particular method may not be adequate for SR cables.

SUMMARY OF THE INVENTION

The foregoing needs are met by the systems and methods for limiting or attenuating an inrush current using electrical passive elements.

In one embodiment, the invention includes a system for reducing inrush current of a self-regulating heating cable. The system includes a power supply configured to provide an input voltage to the self-regulating heating cable. The system further includes a passive element configured to reduce the inrush current. The power supply, the passive element, and the self-regulating heating cable are connected in series.

In another embodiment, the invention includes a system for reducing inrush current of a self-regulating heating cable. The system includes a power supply configured to provide an input voltage to the self-regulating heating cable. Additionally, the system includes a passive element configured to reduce the inrush current. The passive element and the self-regulating heating cable are connected in parallel.

In another embodiment, the invention includes a method for reducing inrush current of a self-regulating heating cable. The method includes opening a switch, and supplying power to the self-regulating heating cable. The method further includes closing the switch after a predetermined amount of time. The switch is connected in parallel to a passive element and the passive element and the switch are connected in series to the self-regulating cable, the passive element configured to reduce the inrush current.

In one embodiment, the invention includes a system for attenuating inrush current of a self-regulating heating cable. The system includes a power supply configured to provide an input voltage to the self-regulating heating cable. The system further includes a passive element configured to reduce the inrush current. Additionally, the system includes a switch configured to selectively connect a first bus-wire to a second bus-wire, the self-regulating heating cable including the first and second bus-wires. The power supply, the passive element, and the self-regulating heating cable are connected in series.

In one embodiment, the invention includes a method for attenuating inrush current of a self-regulating heating cable. The method includes opening a first switch and closing a second switch. The method further includes supplying power to the self-regulating heating cable for a predetermined time. Additionally, the method includes opening the second switch, and closing the first switch. The first switch is connected in parallel to a passive element and the passive element is connected in series to the self-regulating heating cable. The passive element can reduce the peak inrush current, and additionally or alternatively can control, or "tune," the characteristics of the current that is delivered to the bus wires, such as when the bus wires are preheated as described herein. Additionally, the second switch selectively connects a first bus-wire with a second bus-wire.

These and other aspects of the invention will become apparent from the following description. In the description, reference is made to the accompanying drawings which form a part hereof, and in which there is shown embodiments of the invention. Such embodiments do not necessarily represent the full scope of the invention and reference is made therefore, to the claims herein for interpreting the scope of the invention.

BRIEF DESCRIPTION OF THE DRAWINGS

The invention will hereafter be described with reference to the accompanying drawings, wherein like reference numerals denote like elements.

FIG. 1A is a schematic diagram of an inrush current limiting circuit in accordance with an embodiment of the invention.
FIG. 1B is a schematic diagram of an inrush current limiting circuit according to FIG. 1A.
FIG. 1C is a schematic diagram of an inrush current limiting circuit according to FIG. 1A.
FIG. ID is a schematic diagram of an inrush current limiting circuit according to FIG. 1A.
FIG. 2 is a graph showing current over time with an inrush current limiting circuit in accordance with the invention.
FIG. 3A is a schematic diagram of an inrush current limiting circuit in accordance with an embodiment of the invention.
FIG. 3B is a schematic diagram of an inrush current limiting circuit according to FIG. 3A.
FIG. 4 is a schematic diagram of a pre-heating inrush current limiting circuit in accordance with the invention.
FIG. 5 is a graph showing current over time with a pre-heating inrush current limiting circuit in accordance with the invention.

DETAILED DESCRIPTION

Before the present invention is described in further detail, it is to be understood that the invention is not limited to the particular aspects described. It is also to be understood that the terminology used herein is for the purpose of describing particular aspects only, and is not intended to be limiting. The scope of the present invention will be limited only by the claims. As used herein, the singular forms "a", "an", and "the" include plural aspects unless the context clearly dictates otherwise.

It should be apparent to those skilled in the art that many additional modifications beside those already described are possible without departing from the inventive concepts. In interpreting this disclosure, all terms should be interpreted in the broadest possible manner consistent with the context. Variations of the term "comprising", "including", or "having" should be interpreted as referring to elements, components, or steps in a non-exclusive manner, so the referenced elements, components, or steps may be combined with other elements, components, or steps that are not expressly referenced. Aspects referenced as "comprising", "including", or "having" certain elements are also contemplated as "consisting essentially of" and "consisting of" those elements, unless the context clearly dictates otherwise. It should be appreciated that aspects of the disclosure that are described with respect to a system are applicable to the methods, and vice versa, unless the context explicitly dictates otherwise.

Numeric ranges disclosed herein are inclusive of their endpoints. For example, a numeric range of between 1 and 10 includes the values 1 and 10. When a series of numeric ranges are disclosed for a given value, the invention expressly contemplates ranges including all combinations of the upper and lower bounds of those ranges. For example, a numeric range of between 1 and 10 or between 2 and 9 is intended to include the numeric ranges of between 1 and 9 and between 2 and 10.

It will be appreciated by those skilled in the art that while the invention is described below in connection with self-regulating (SR) heating cables, the systems and methods are not limited to SR heating cables. Rather, the invention generally relates to any application where limiting a high inrush current is desirable.

As stated above, when an SR heating cable is energized, an initial inrush current may be extremely high. Attenuating initial inrush current (e.g. "soft starting" an SR cable) may overcome the issues associated with a high initial inrush current. In some embodiments, attenuating the initial inrush current may allow for the downsize of the current ratings of circuit breakers and/or the relays. Further, in some embodiments, the maximum circuit length may be expanded. Specifically, the maximum circuit length may be expanded for SR heaters with traditionally significant inrush currents.

In one embodiment of the invention, an external electrical passive element may be used to limit the inrush current. The passive element may be any external element or any combination of external elements. The inclusion of the passive element may enable the soft-start of SR heating cables via the reduction in the inrush current; accordingly, the conventional need for larger circuit breaker sizes for certain applications may be diminished. Non-limiting examples of the passive element include a resistor, an inductor, a capacitor, or any combination of these external elements.

In some embodiments, the passive element may be connected to the beginning of the SR heating cable. Alternatively, the passive element may be connected at the end of the SR heating cable. In some situations, the passive element may be disposed at any location along the cable length. Specific applications may guide placement of the passive element in relation to the other circuit elements.

In one embodiment of the invention, the bus-wires of the heating cable may be connected together at the end of the SR cable for a predetermined amount of time. Additionally, an external electrical passive element may be used in series with the SR cable to tune the bus-wire currents. Accordingly, the inrush current of the SR cable may be reduced.

In some embodiments, the predetermined amount of time may be a few minutes. Specifically, in some situations it may be beneficial to have the bus-wires of the heating cable connected from 30 seconds to 10 minutes. In some situations, it may be beneficial to have the bus-wires of the heating cable connected from a few seconds to 1 hour.

In some embodiments, the bus-wire connection may occur at the end of the SR heating cable. Due to this connection, the bus-wires may act as a resistor, for example, and heat up the core of the SR cable. Accordingly, the heating of the SR cable core may enable the soft-start of SR heating cables via the reduction in the inrush current.

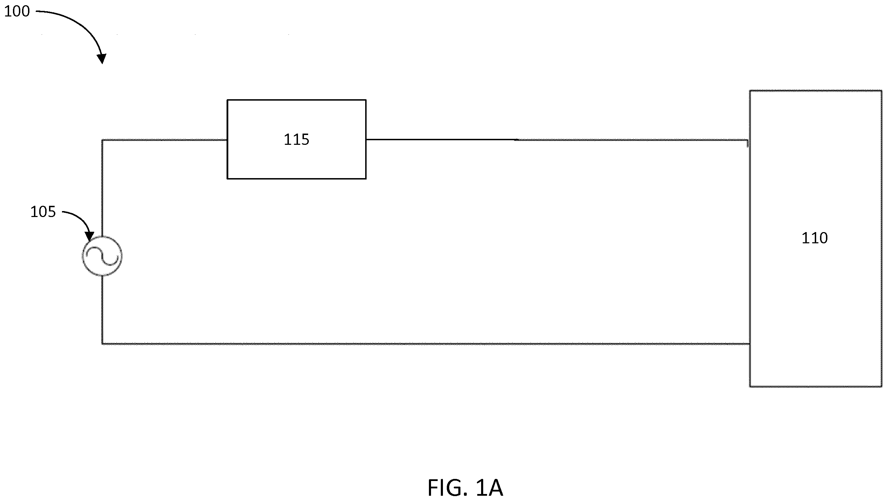

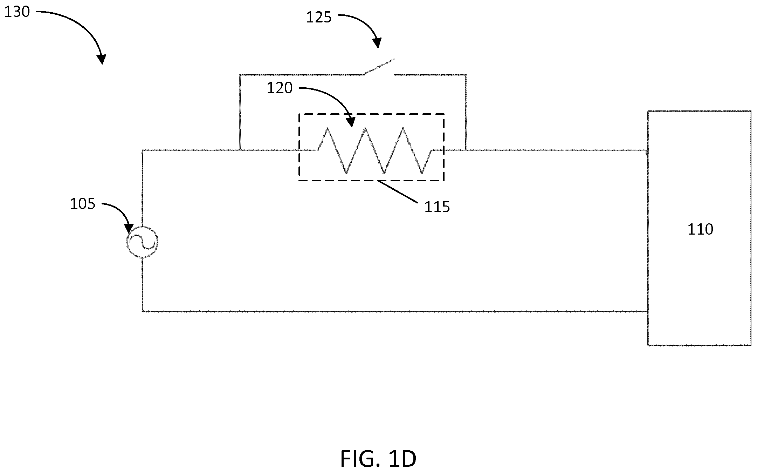

FIGs. 1A through ID show inrush circuits 100, 130 according to an embodiment of the invention. The inrush circuits 100, 130 may include a power source 105, connected to and configured to supply power to an SR heating cable 110.

Referring to FIG. 1A, one configuration of the inrush circuit 100 is shown. Generally, the inrush circuit 100 may include a passive element 115. The passive element 115 may be connected in series with the SR heating cable 110. Accordingly, the passive element 115 may be configured to reduce an initial inrush current associated with powering the SR heating cable 110 via the power source 105. As previously described, the passive element 115 may include at least one external (i.e., outside of the SR heating cable 110) electrical passive element. In some embodiments, the passive element 115 may include a combination of external electrical passive elements.

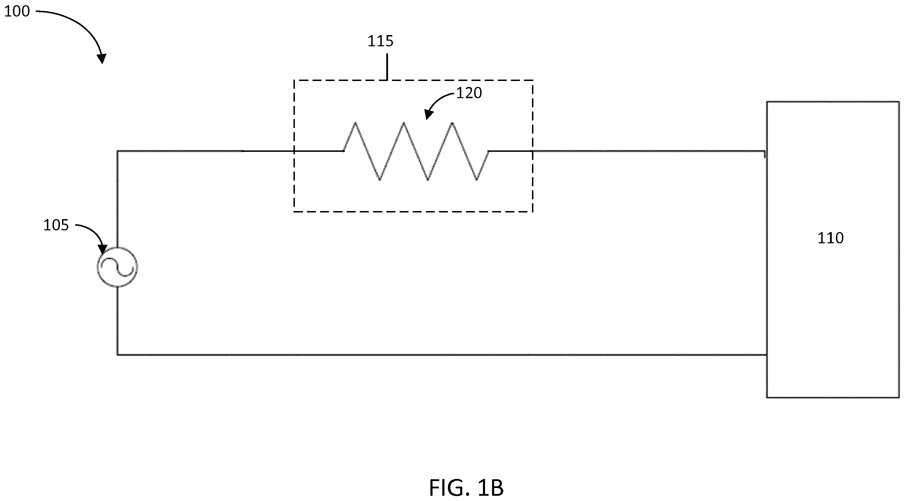

Referring to FIG. 1B, another configuration of the inrush circuit 100 is shown. The inrush circuit may include the passive element 115. Here, the passive element 115 may include a resistor 120 connected in series with the SR heating cable 110. The series connection limits the current flowing through the SR heating cable 110.

In some embodiments, the current flowing through the resistor 120 and the wire dissipates heat, thus heating up the SR heating cable 110. The resistance of the SR heating cable 110 may increase when the SR heating cable 110 is heated over time. The heating over time may therefore limit the overall inrush current as time passes.

When power is originally applied to an SR heating cable 110, its resistance may be minimal. Accordingly, the initial current may be very large. The initial current may begin to decrease once the SR heating cable 110 begins to heat up.

Adding the resistor 120 may attenuate the initial current, allowing the SR heating cable 110 to heat up (while being exposed to less voltage across it), and its resistance to increase. Accordingly, the SR heating cable 110 may be subject to lower electrical current via the resistor 120. When equilibrium is achieved, the voltage drop and power dissipated by the resistor 120 may be very small compared to the values for the SR heating cable 110.

In some embodiments, the resistance value of the resistor 120 may be any value that provides inrush current reduction. In some situations, however, it may be beneficial to select the resistance value of the resistor 120 based on the desired application. In some embodiments, the resistance of the resistor 120 may be approximately equal to the resistance of the SR heating cable 110 at the desired start-up temperature.

In some embodiments, the resistor 120 may be a zero temperature coefficient (ZTC) resistor. A ZTC resistor may generally be defined as a resistor with a temperature coefficient less than a predetermined threshold resistance value. Further, materials with a temperature coefficient of resistance (TCR) value less of less than 0.007 1/K can be referred to as a zero temperature coefficient (ZTC) material.

In some embodiments, it may be desirable to reduce or remove the effect of the external passive element 115 after the inrush current is attenuated. For example, the SR heating cable 110 application may require that the power dissipated by the resistor 120 should not remain after the initial time; the resistor 120 may be switched out of the circuit via an external switch, relay, SSR circuit, or the like, after the SR heating cable 110 current has almost reached a steady-state current at which the SR heating cable 110 is rated to operate.

One non-limiting example is provided, wherein the resistance value of the resistor 120 is assumed to be approximately equal to the resistance of the SR heating cable 110 at the desired start-up temperature. The total resistance ($R_{total}$) will be the summation of the resistor 120 ($R_{external}$) and the resistance of the cable ($R_{cable}$), yielding the equation below:

$$R_{total} = R_{cable} + R_{external} \qquad (1)$$

When power is applied to the SR heating cable 110 initially at the desired start-up temperature, the resistance of the heating cable ($R_{cable}$) is small, and may be estimated where:

$$R_{external} = R_{cable} \qquad (2)$$

Equation 2 thus yields:

$$R_{total} = 2R_{cable} \qquad (3)$$

As a result, the peak inrush current may be reduced by a factor of two, and the SR heating cable 110 may be heated via soft starting. As time increases, the temperature of the SR heating cable 110 may increase. Due to the PTC characteristics of the SR heating cable 110, the resistance of the SR heating cable 110 may increase. At the same time, the power dissipated by the resistor 120 may become smaller while the voltage from the power source 105 remains constant. The following equation describes the power being dissipated by the resistor 120:

$$P_{external\ resistor} = \frac{R_{external}}{(R_{external}+R_{cable})^2} \times V_{Source}{}^2 \qquad (4)$$

When a steady-state is achieved (i.e., the current in the SR heating cable 110 stabilizes at a steady-state current), $R_{cable}$ may be much larger than $R_{external}$, hence the power being dissipated by the resistor 120 at steady-state may be small. Therefore, in some embodiments the resistor 120 may be left in series, if the associated $P_{external}$ is acceptable for the application.

The presence of the resistor 120 may result in a softening of the voltage across the SR heating cable 110 as the voltage starts low and gradually climbs up to a steady state value. This behavior resembles the performance that can be achieved using the "Autotransformer," and can be explained as follows:

$$V = I \times (R_{cable} + R_{resistor}) \qquad (5)$$

$$V_{cable} = (I \times R_{cable}) \qquad (6)$$

$$V_{cable} = V \times \frac{R_{cable}}{R_{cable}+R_{Resistor}} \qquad (7)$$

As shown by Equation 7, the voltage across the SR cable is directly related to the ratio of the cable resistance and total resistance (resistance ratio), whereas the SR cable resistance rises in time as the cable heats up. Hence, the SR cable experiences a gradually increasing voltage after the circuit is energized.

Furthermore, the steady state voltage of the SR cable is always smaller than the applied voltage due to the fact that the resistance ratio will always be smaller than 1 when the external resistor is included in the electrical circuit (i.e., is not bypassed, such as by a switch as described herein). Accordingly, the steady state cable power declines when an external resistor is present.

In some embodiments, it may be desirable to reduce or remove the effect of the external passive element 115 after the inrush current is attenuated. For example, the heating cable 110 application may require that the power dissipated by the resistor 120 should not remain after the initial time; the resistor 120 may be switched out of the circuit via an external switch, relay, SSR circuit, or the like, after the SR heating cable 110 current has almost reached the steady-state current.

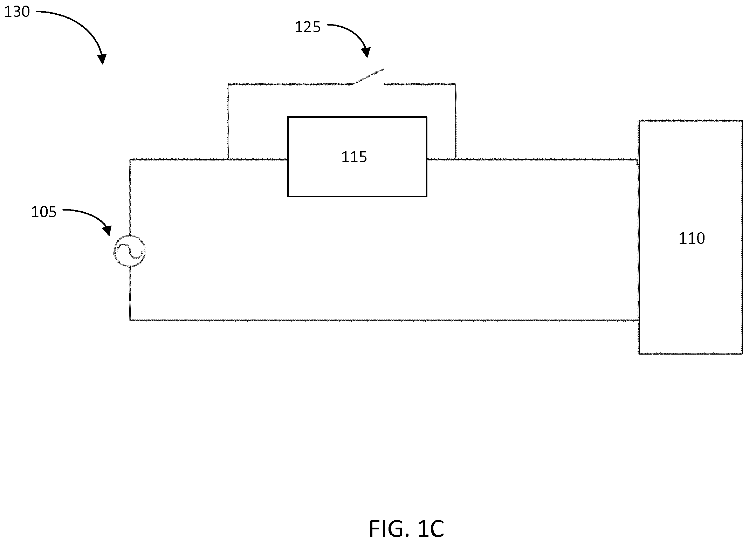

FIGs. 1C through ID show additional configurations of an inrush circuit 130 in which electric current can be diverted from the passive element 115. Referring to FIG. 1C, a switch 125 may be connected in parallel to the passive element 115. In some embodiments, the switch 125 may be open during start-up of the SR heating cable 110, and may be closed once the SR heating cable 110 approaches its steady-state current.

FIG. ID includes the resistor 120 within the passive element 115. Here, the resistor 120 is connected in parallel to the switch 125. The advantages of including the switch 125 are discussed above. Accordingly, the switch 125 may be open during start-up of the SR heating cable 110, and may be closed once the SR heating cable 110 approaches its steady-state current.

In some embodiments, the passive element 115 may include at least one resistor and/or at least one inductor. Additional electrical passive circuit elements may be included within the passive element 115. The electrical passive circuit elements may be selected based upon a desired passive element resistance.

For example, a mineral-insulated (MI) cable may be used as the passive element 115, providing a resistance as described above with respect to the resistor 120. In some embodiments, the MI cable may be used to tolerate the power dissipation during the initial high current period. In certain situations, the MI cable may be selected based on length and/or resistance so as to withstand the initial high current period. In some situations, it may be beneficial to use an inductor in-place of a resistor for the passive element 115. In situations with long cables, it may be beneficial to use an inductor as the passive element 115. The inductor may provide the additional benefit of a filtering effect.

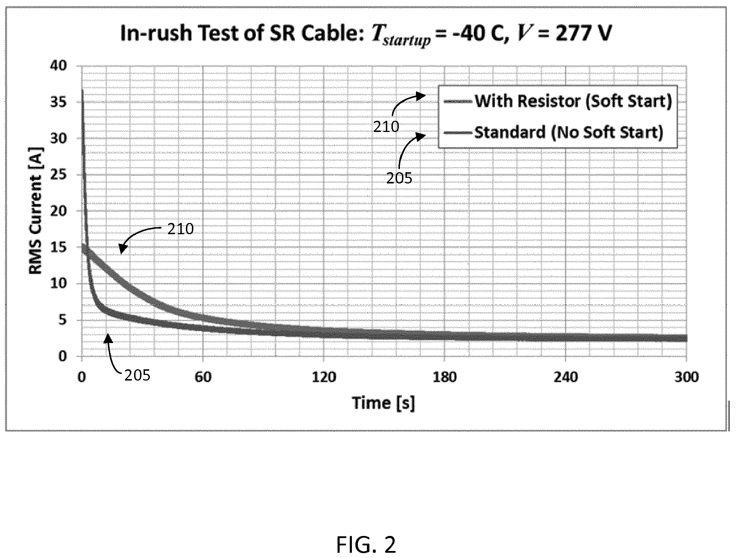

FIG. 2 shows a graph comparing the inrush current profile for an SR heating cable with and without a resistor. Data 205 corresponds to an SR heating cable without a resistor (a conventional SR heating cable). Data 210 corresponds to an SR heating cable with a resistor, according to the invention. The start-up temperature was provided as -40 degrees Celsius, and the applied voltage was set at 277 volts. As can be seen by the graph, the peak RMS inrush current drops from 37 A to 15 A when the resistor is included with the SR heating cable.

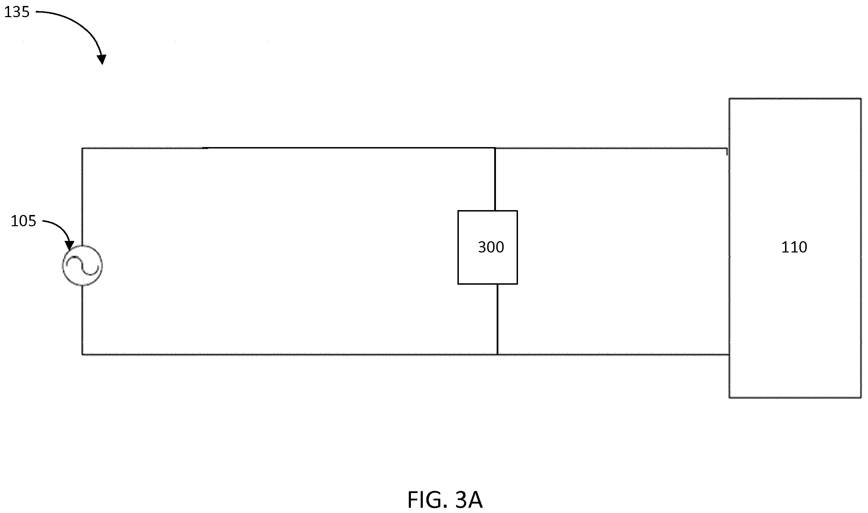

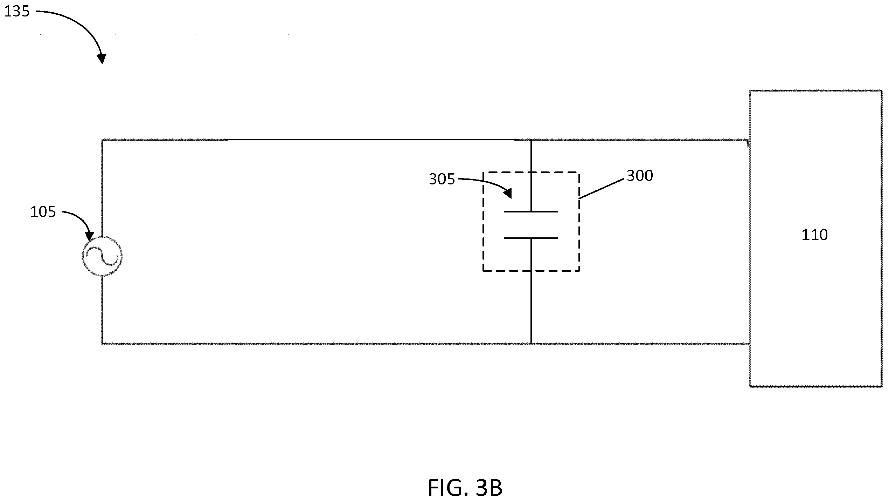

In another embodiment, a passive element may be connected in parallel to an SR heating cable and configured to favorably attenuate the inrush current. FIGs. 3A and 3B show an inrush circuit 135 where a passive element 300 is connected in parallel to the SR heating cable 110. Specifically, FIG. 3B depicts the inrush circuit 135 where the passive element 300 may include a capacitor 305. In applications where the passive element 300 includes the capacitor 305, additional filtering benefits may occur due to the reduction in harmonics. Additional electrical passive circuit elements may be included within the passive element 300.

As discussed above, the bus-wires of the heating cable may be connected together at the end of the SR cable for a predetermined amount of time. This may reduce the inrush current of the SR heating cable.

In one embodiment, the current may flow through the bus-wires and dissipate heat, thus heating up the core of the SR heating cable. The resistance of the SR heating cables may increase when the SR heating cable is heated over time. Accordingly, this may limit the overall current when the cable is normally energized at a later stage.

When power is initially applied to an SR heating cable, the heating cable resistance may be very low, hence, the initial current may be very large and declines once the SR heating cable begins to heat up. Therefore, the bus-wire heating may be used to initially heat up the core. Accordingly, the bus-wire contact at the end of SR cable may be opened and the passive element may be bypassed after pre-heating. Once bypassed, the SR cable may be connected to the power supply normally. Notably, the resistance of the preheated SR cable core may increase due to R-T behavior, thus allowing the SR cable to experience lower electrical inrush current. Additionally, the invention may enable the reduction of wiring infrastructure.

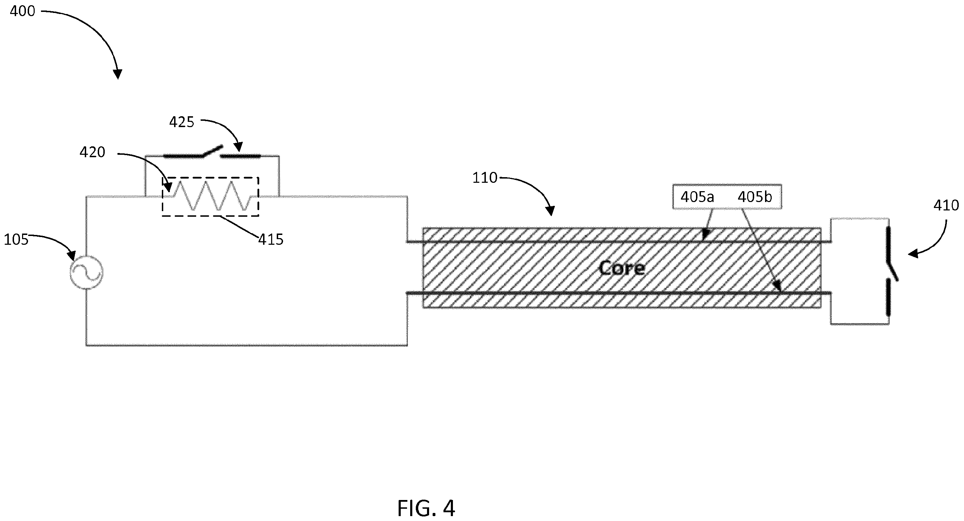

FIG. 4 is a schematic diagram illustrating a pre-heating circuit 400 in accordance with the invention. The pre-heating circuit 400 may include a switch 410 that selectively connects bus-wires 405a, 405b. In some embodiments, the switch 410 may be located towards the end of the SR heating cable 110. In normal operation (i.e., when the heating cable 110 is generating heat through resistive heating of the PTC material), the switch 410 is open and the circuit 400 is completed or nearly completed by electric current flowing from a first bus-wire 405a to a second bus-wire 405b through the core of the heating cable 110. When the switch 410 is closed, the bus-wires 405a, 405b may be electrically connected to each other, completing the circuit 400 through the switch 410 for the excess inrush current. Accordingly, when the switch 410 is opened, the bus-wires 405a, 405b may be disconnected from each other. A switch 425 may be used for bypassing the resistor after the predetermined preheat time. Additionally, the switch 410 may be opened after the predetermined preheat time.

As one non-limiting embodiment, a passive element 415 may include a resistor 420. The resistance value of the resistor 420 effectively may be any value providing enough current to preheat the core and may be sized with circuit breaker rating. In some situations, best results may be obtained by tuning the value for higher preheat current.

As one non-limiting example, the resistance value of the resistor 420 is assumed to be $R_{external}$, and the resistance of each bus-wire 405a, 405b of the SR heating cable 110 may be assumed to be $R_{buswire}$. When the switch 425 is opened and the switch 410 is closed, the total resistance ($R_{total}$) may be the summation of the resistor 420 ($R_{external}$) and the resistance of the bus-wires 405a, 405b, yielding the equation below:

$$R_{total} = R_{external} + 2R_{buswire} \qquad (1)$$

When power is applied to the SR heating cable 110, initially at the desired start-up temperature, the current flow through the bus-wires 405a, 405b may be calculated from the equation below:

$$I = \frac{V_{Source}}{(R_{external} + 2R_{buswire})} \qquad (2)$$

The bus-wires 405a, 405b may act like heating elements and increase the temperature of the SR cable core. After a predetermined amount of time for preheating, the switch 410 may be opened, and then the switch 425 may be closed to bypass the resistor 420. Accordingly, the SR heating cable 110 may be connected to the power source 105 directly. As a result, the inrush current may be reduced due to the increased resistance of the SR heating cable 110 after initial preheating time.

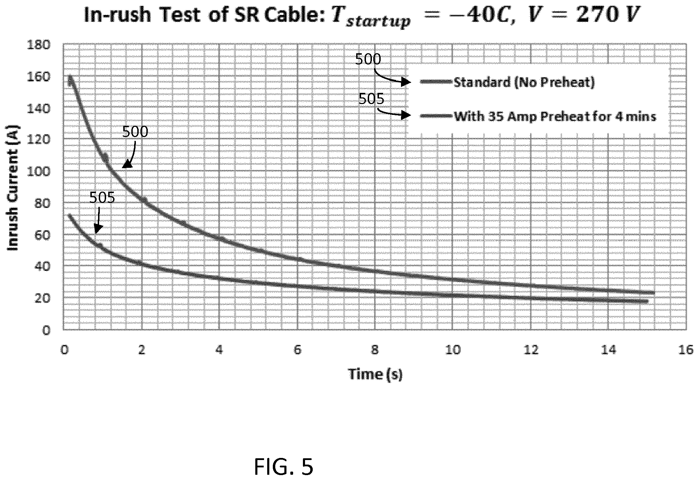

FIG. 5 shows the inrush current profile of an SR heating cable. Here, the startup temperature is -40 degrees Celsius and the applied voltage is 270 volts (AC). In some embodiments, -40 degrees Celsius may be the lowest startup temperature. Data 500 shows a standard SR heating cable's inrush current over time. Data 505 shows an SR heating cable's inrush current over time, according to the invention. Specifically, data 505 shows an inrush current after a preheat current of 35 A was applied to the bus-wires for 4 minutes. As shown by FIG. 5, the peak inrush current drops from 160 A to 72 A when utilizing the presently disclosed preheating system and method. Notably, not only may the peak inrush current be reduced, but the invention may also reduce the overall inrush current, as demonstrated by FIG. 5. Nuisance tripping occurs with SR cables, and the bus-wire preheating may desirably reduce the entirety of the inrush current.

In addition, a duty cycling strategy may be implemented along with the passive element, according to the invention. The duty cycling strategy may further enhance the performance of the present system's inrush current management.

The invention provides an efficient inrush performance improvement. Additionally, the invention may be used with existing and standard SR heating cables, and does not need to necessarily be integrated during the manufacturing of the SR heating cables. In one aspect, the invention is a system for reducing inrush current of a self-regulating heating cable, the system comprising a power supply configured to provide an input voltage to the self-regulating heating cable, and a passive element configured to reduce the inrush current; the power supply, the passive element, and the self-regulating heating cable are connected in series. The passive element can be configured to reduce both a peak inrush current and an overall inrush current. The passive element can include at least one of a resistor and an inductor, and the resistor can be a ZTC resistor. The system can further comprise a switch connected in parallel to the passive element. The passive element can be configured such that a passive element resistance is approximately equal to an initial self-regulating heating cable resistance. The initial self-regulating heating cable resistance can be determined based on a desired start-up temperature.

In another aspect, the invention is a system for reducing inrush current of a self-regulating heating cable, the system comprising a power supply configured to provide an input voltage to the self-regulating heating cable, and a passive element configured to reduce the inrush current; the passive element and the self-regulating heating cable are connected in parallel. The passive element can be configured to reduce both a peak inrush current and an overall inrush current. The passive element can comprise at least one resistor, and the resistor can be a ZTC resistor. Additionally or alternatively, the passive element can include a capacitor.

In yet another aspect, the invention is a method for reducing inrush current of a self-regulating heating cable, the method comprising: a) opening a switch; b) supplying power to the self-regulating heating cable; and c) closing the switch after a predetermined amount of time, wherein the switch is connected in parallel to a passive element and the passive element and the switch are connected in series to the self-regulating heating cable, the passive element configured to reduce the inrush current. The method can further comprise one or more of the following steps: reducing both a peak inrush current and an overall inrush current via the passive element; selecting the passive element such that a passive element resistance is approximately equal to an initial self-regulating heating cable resistance; and, determining the initial self-regulating heating cable resistance based on a desired start-up temperature.

In yet another aspect, the invention is a system for attenuating inrush current of a self-regulating heating cable, the system comprising: a power supply configured to provide an input voltage to the self-regulating heating cable; a passive element configured to reduce the inrush current; and, a switch configured to selectively connect a first bus-wire to a second bus-wire, the self-regulating heating cable including the first and second bus-wires, and the power supply, the passive element, and the self-regulating heating cable being connected in series. In various embodiments: at least one of the passive element and the switch is configured to reduce both a peak inrush current and an overall inrush current; the passive element includes a resistor; the system further comprises a second switch connected in parallel to the passive element; an initial self-regulating heating cable resistance is determined based on a desired start-up temperature; and, the passive element comprises at least one resistor and at least one inductor.

In still another aspect, the invention is a system for attenuating inrush current of a self-regulating heating cable, the system comprising: a power supply configured to provide an input voltage to the self-regulating heating cable; a passive element configured to reduce the inrush current; and, a switch configured to selectively connect a first bus-wire to a second bus-wire, the self-regulating heating cable including the first and second bus-wires, and the passive element and the self-regulating heating cable being connected in parallel. In various embodiments: at least one of the passive element and the switch is configured to reduce both a peak inrush current and an overall inrush current; the passive element comprises at least one resistor and at least one capacitor; and, the passive element is a capacitor.

In still another aspect, the invention is a method for attenuating inrush current of a self-regulating heating cable, the method comprising the steps of : a) opening a first switch; b) closing a second switch; c) supplying power to the self-regulating heating cable for a predetermined time; d) opening the second switch; and e) closing the first switch, the first switch connecting in parallel to a passive element and the passive element connecting in series to the self-regulating heating cable, the passive element configured to reduce the inrush current, and the second switch selectively connecting a first bus-wire of the self-regulating heating cable with a second bus-wire of the self-regulating heating cable. The method can include one or more of the following steps: reducing both a peak inrush current and an overall inrush current via at least one of the first and the second switch; determining an initial self-regulating heating cable resistance based on a desired start-up temperature; and, opening the second switch by disconnecting the first bus-wire from the second bus-wire. In various embodiments: the predetermined time is between 30 seconds and 10 minutes; the predetermined time is selected based on a desired input current level; and, the predetermined time is selected based on a desired bus-wire temperature and start-up temperature.

It will be appreciated by those skilled in the art that while the invention has been described above in connection with particular embodiments and examples, the invention is not necessarily so limited, and that numerous other embodiments, examples, uses, modifications and departures from the embodiments, examples and uses are intended to be encompassed by the claims attached hereto. Various features and advantages of the invention are set forth in the following claims.

## Claims

1.   An inrush circuit for attenuating inrush current of a self-regulating heating cable, the inrush circuit comprising:

     a passive element electrically connecting between the heating cable and a power supply configured to provide an input voltage to the heating cable, the passive element configured to reduce the inrush current; and
     a first switch electrically connecting to a first bus-wire and a second bus-wire of the heating cable, the first switch movable between a closed position that electrically connects the first bus-wire to the second bus-wire through the first switch, and an open position that electrically disconnects the first bus-wire from the second bus-wire through the first switch.

2.   The inrush circuit of claim 1, wherein at least one of the passive element and the first switch is configured to reduce both a peak inrush current and an overall inrush current.

3.   The inrush circuit of claim 1 or claim 2, wherein the passive element includes a zero temperature coefficient resistor electrically connected in series between the power supply and the heating cable.

4.   The inrush circuit of claim 1, claim 2 or claim 3, wherein the passive element comprises a mineral-insulated cable electrically connected in series between the power supply and the heating cable.

5.   The inrush circuit of claim 1 or of any of claims 2 to 4, further comprising a second switch electrically connecting between the power supply and the heating cable in parallel to the passive element, the second switch movable between a closed position that electrically bypasses the passive element, and an open position that causes electric current flowing between the power supply and the heating cable to pass through the passive element, the inrush circuit attenuating the inrush current when the first switch is in the closed position and the second switch is in the open position.

6.   The inrush circuit of claim 1 or of any of claims 2 to 5, wherein the heating cable comprises a core including the first and second bus-wires and positive temperature coefficient (PTC) material encapsulating the first and second bus-wires, and the passive element comprises a resistor having a resistance value selected, based at least in part on an initial resistance of the heating cable at start-up, to provide sufficient current to the heating cable to preheat the core, the initial resistance being determined based on a predetermined start-up temperature of the heating cable.

7.   The inrush circuit of claim 6, wherein the passive element further comprises at least one inductor.

8.   The inrush circuit of claim 1 or of any of claims 2 to 7, wherein the passive element comprises a capacitor electrically connected in parallel between the power supply and the heating cable.

9.   The inrush circuit of claim 1 or of any of claims 2 to 8, wherein the power supply and the passive element electrically connect to the heating cable at a first end of the heating cable, and the first switch electrically connects to the first and second bus-wires at a second end of the heating cable opposite the first end.

10.   A method of attenuating an inrush current of a self-regulating heating cable, the method comprising:

electrically connecting an inrush circuit to the heating cable and to a power supply configured to provide an input voltage to the heating cable, the inrush circuit comprising:

a passive element that electrically connects between the heating cable and the power supply, the passive element configured to dissipate a portion of the inrush current; and

a first switch that electrically connects to a first bus-wire and a second bus-wire of the heating cable, the first switch movable between a closed position that electrically connects the first bus-wire to the second bus-wire through the first switch, and an open position that electrically disconnects the first bus-wire from the second bus-wire through the first switch;

positioning the first switch in the closed position;

energizing the heating cable at a start-up time; and

at a pre-heating time a duration after the start-up time, positioning the first switch in the open position, the duration being associated with achievement of a steady-state current in the heating cable.

11. The method of claim 10, wherein the passive element comprises a resistor having a resistance value selected, based at least in part on an initial resistance of the heating cable at the start-up time, to provide sufficient current to the heating cable to preheat the heating cable, the initial resistance being determined based on a predetermined start-up temperature of the heating cable, the method further comprising determining the duration based at least in part on the initial resistance and the predetermined start-up temperature.

12. The method of claim 10 or claim 11, wherein the heating cable comprises a core including the first and second bus-wires and positive temperature coefficient (PTC) material encapsulating the first and second bus-wires, the method further comprising selecting, as the passive element, a resistor having a resistance value selected, based at least in part on an initial resistance of the heating cable at start-up, to provide sufficient current to the heating cable to preheat the core, the initial resistance being determined based on a predetermined start-up temperature of the heating cable.

13. The method of claim 10, claim 11 or claim 12, wherein the passive element is one of a zero temperature coefficient resistor and a length of a mineral-insulated cable, and electrically connecting the inrush circuit to the power supply and the heating cable comprises electrically connecting the passive element to the power supply and to the first bus-wire in series.

14. The method of claim 10 or of any of claims 11 to 13, wherein electrically connecting the inrush circuit to the power supply and the heating cable comprises:

electrically connecting the passive element between the power supply and the heating cable at a first end of the heating cable; and

electrically connecting the first switch to the first bus-wire and the second bus-wire at a second end of the heating cable opposite the first end.

15. The method of claim 14, wherein:

the passive element is a resistor;

the inrush circuit further comprises a second switch movable between a closed position that allows electric current to flow through the second switch, and an open position that prevents electric current from flowing through the first switch;

electrically connecting the inrush circuit to the power supply and the heating cable further comprises:

electrically connecting the resistor between the power supply and the heating cable in series; and

electrically connecting the second switch to the power supply and the heating cable in parallel with the resistor, such that the current flowing between the power supply and the heating cable bypasses the resistor when the second switch is in the closed position, and flows through the resistor when the second switch is in the open position; and

the method further comprises:

before energizing the heating cable, positioning the second switch in the open position; and

at the pre-heating time, positioning the second switch in the closed position.

FIG. 1A

FIG. 1B

FIG. 1C

FIG. 1D

**In-rush Test of SR Cable:** $T_{startup}$ = -40 C, $V$ = 277 V

FIG. 2

EP 3 481 146 A1

FIG. 3A

FIG. 3B

400

110

410

405a  405b

Core

425

420

415

105

FIG. 4

In-rush Test of SR Cable: $T_{startup} = -40C, V = 270\,V$

FIG. 5

Europäisches
Patentamt

European
Patent Office

Office européen
des brevets

# EUROPEAN SEARCH REPORT

Application Number

EP 18 20 4472

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2010/059502 A1 (O'CONNOR JASON DANIEL HAROLD [GB]) 11 March 2010 (2010-03-11)<br>* abstract *<br>* paragraph [0001] *<br>* paragraph [0005] *<br>* paragraph [0012] - paragraph [0022] *<br>* paragraph [0033] - paragraph [0036] *<br>* paragraph [0050] - paragraph [0054] *<br>* paragraph [0058] *<br>* paragraph [0064] - paragraph [0074] *<br>* figures 1-8 * | 1-15 | INV.<br>H05B3/56<br>H05B3/00 |
| A | GB 1 155 118 A (DREAMLAND ELECTRICAL APPLIANCE) 18 June 1969 (1969-06-18)<br>* abstract *<br>* page 1, line 12 - line 27 *<br>* page 1, line 50 - page 2, line 30 *<br>* page 2, line 60 - line 96 *<br>* figures 1-4 * | 1-15 | |
| A | GB 2 075 777 A (SUNBEAM CORP) 18 November 1981 (1981-11-18)<br>* page 2, line 38 - page 3, line 115 *<br>* figures 1-7 * | 1-15 | **TECHNICAL FIELDS SEARCHED (IPC)**<br><br>H05B |

The present search report has been drawn up for all claims

| Place of search | Date of completion of the search | Examiner |
|---|---|---|
| Munich | 20 March 2019 | Chelbosu, Liviu |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.....................................................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 18 20 4472

This annex lists the patent family members relating to the patent documents cited in the above-mentioned European search report.
The members are as contained in the European Patent Office EDP file on
The European Patent Office is in no way liable for these particulars which are merely given for the purpose of information.

20-03-2019

| Patent document cited in search report | | | Publication date | Patent family member(s) | | | Publication date |
|---|---|---|---|---|---|---|---|
| US 2010059502 | A1 | | 11-03-2010 | CA | 2592074 | A1 | 29-06-2006 |
| | | | | CN | 101138277 | A | 05-03-2008 |
| | | | | EP | 1829425 | A1 | 05-09-2007 |
| | | | | US | 2010059502 | A1 | 11-03-2010 |
| | | | | WO | 2006067485 | A1 | 29-06-2006 |
| GB 1155118 | A | | 18-06-1969 | AU | 426931 | B2 | 08-08-1972 |
| | | | | BE | 735359 | A | 30-12-1969 |
| | | | | CH | 498544 | A | 31-10-1970 |
| | | | | DE | 1929855 | A1 | 23-12-1970 |
| | | | | GB | 1155118 | A | 18-06-1969 |
| GB 2075777 | A | | 18-11-1981 | AR | 227041 | A1 | 15-09-1982 |
| | | | | AU | 542163 | B2 | 07-02-1985 |
| | | | | BE | 888195 | A | 16-07-1981 |
| | | | | BR | 8101977 | A | 06-10-1981 |
| | | | | CA | 1156300 | A | 01-11-1983 |
| | | | | DE | 3111911 | A1 | 04-03-1982 |
| | | | | FR | 2485285 | A1 | 24-12-1981 |
| | | | | GB | 2075777 | A | 18-11-1981 |
| | | | | JP | S57864 | A | 05-01-1982 |
| | | | | JP | S6412073 | B2 | 28-02-1989 |
| | | | | MX | 149294 | A | 10-10-1983 |
| | | | | NL | 8101632 | A | 02-11-1981 |
| | | | | NZ | 196568 | A | 30-04-1985 |
| | | | | ZA | 8102180 | B | 28-07-1982 |

EPO FORM P0459

For more details about this annex : see Official Journal of the European Patent Office, No. 12/82

**EP 3 481 146 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 62581231 B